# EUROPÄISCHE PATENTSCHRIFT

(11) **EP 3 669 014 B1**
(45) Veröffentlichungstag und Bekanntmachung des Hinweises auf die Patenterteilung: **07.08.2024**
(21) Anmeldenummer: 18755814.3
(22) Anmeldetag: 16.08.2018
(51) Int. Cl.: C23C 16/27, C23C 16/46

(54) **VERFAHREN ZUM BESCHICHTEN TEMPERATUREMPFINDLICHER SUBSTRATE MIT POLYKRISTALLINEM DIAMANT**
METHOD FOR COATING TEMPERATURE-SENSITIVE SUBSTRATES WITH POLYCRYSTALLINE DIAMOND
PROCÉDÉ POUR RECOUVRIR DES SUBSTRATS THERMOSENSIBLES DE DIAMANT POLYCRISTALLIN

(30) Priorität: 18.08.2017 DE 102017214432; 29.09.2017 DE 102017217464
(43) Veröffentlichungstag der Anmeldung: 24.06.2020
(73) Patentinhaber: Gühring KG, 72458 Albstadt (DE)
(72) Erfinder: GARRN, Immo, 88521 Ertingen (DE)
(74) Vertreter: Winter, Brandl - Partnerschaft mbB
(86) Internationale Anmeldenummer: PCT/EP2018/072193
(87) Internationale Veröffentlichungsnummer: WO 2019/034728

(56) Entgegenhaltungen:
- EP-A1- 0 687 753
- CN-A- 106 756 880
- JP-A- H0 917 325
- US-A- 5 146 481
- US-A1- 2006 219 158
- US-A1- 2013 230 715
- US-B1- 6 632 127

## Beschreibung

Die vorliegende Erfindung betrifft ein Verfahren zum Beschichten von Funktionsbereichen spanabhebender Werkzeuge oder Schneidsätze mit polykristallinem Diamant in einem Heißdraht-CVD-Verfahren gemäß dem Oberbegriff des Anspruchs 1.

CVD-Diamantabscheideverfahren sind bereits seit 1982 verfügbar [Matsumoto S, et al. (1982): "Vapor deposition of diamond particles from methane." Jpn J Appl Phys; 21 (4): L183-5].

Eine Übersicht über den heutigen Stand der industriell eingesetzten CVD-diamantbeschichteten Werkzeuge und insbesondere spanabhebenden Schneidwerkzeuge und deren Nutzungspotential sowie unterschiedliche CVD-Diamantbeschichtungsverfahren findet sich in der Dissertation von Fiona Sammler unter dem Titel "Steigerung der Nutzungspotentiale von CVD-diamantbeschichteten Werkzeugen" der Fakultät V-Verkehrs- und Maschinensysteme der Technischen Universität Berlin vom 17.04.2015.

Die chemische Gasphasenabscheidung erlaubt es, Diamantschichten direkt auf Werkzeugsubstraten, auch auf solchen mit komplexen Geometrien, abzuscheiden. Dies ermöglicht beispielsweise im Gegensatz zum weit verbreiteten Schneidstoff aus polykristallinem Diamant (PKD) der in Form von Blanks auf einen Hartmetallträger gelötet wird, eine insgesamt höhere geometrische Flexibilität der Werkzeuge.

Eine relativ einfache Möglichkeit, auf einem Funktionsbereich eines Werkzeugs eine Diamantbeschichtung aufzubringen, ist das so genannte Heißdraht-CVD-Verfahren, bei welchem ein Dampfabscheideverfahren durchgeführt wird durch Reaktion von Methan und Wasserstoff in einem Vakuum an einem heißen Wolframdraht, um den im Hochvakuum erzeugten Kohlenstoff auf der Substratoberfläche in seiner kubisch kristallinen Diamantmodifikation abzuscheiden.

Hierbei wird typischerweise der Wolframdraht mit einer konstanten elektrischen Leistung versorgt, um den Draht während der gesamten Abscheidung des Diamantfilms auf einer konstanten Temperatur zwischen 2000°C und 3000°C zu halten.

Insbesondere müssen an den Heizdrähten Temperaturen >2000°C herrschen, um beim Heißdraht-CVD-Beschichten technisch und wirtschaftlich sinnvolle Diamantabscheideraten zu erreichen und um die Zersetzungsreaktionen der Reaktionsgase auszulösen. Solche konstanten Temperaturen zwischen 2000 und 3000°C führen jedoch zwangsläufig zu einer Aufheizung der gesamten Reaktionskammer, so dass Arbeitstemperaturen zwischen 800°C und 1000°C erreicht werden.

Für viele Substrate ist diese Temperatur zu hoch, als dass sie den Beschichtungsprozess ohne Veränderung ihrer anwendungsrelevanten Eigenschaften überstehen würden. Stahl wird beispielsweise weich geglüht und erfährt Gefügeveränderungen oder gesinterte polykristalline Diamantschneideinsätze werden graphitisiert, d.h. der kubisch kristalline Diamant wandelt sich wieder in den hexagonalen Graphit um, wodurch die erwünschte Härte und der erhöhte tribilogische Widerstand signifikant leiden können oder gar verloren gehen.

Ferner ist aus dem Stand der Technik der DE 198 26 259 A1 ein Plasma-CVD-Verfahren zum Beschichten eines Substrates mit Kohlenstoff, insbesondere amorphem Kohlenstoff, oder Silicium bekannt, bei welchem an das elektrisch leitende Substrat zur Steuerung des Ionenbeschusses während der Beschichtung einer unabhängig vom Beschichtungsplasma erzeugte Substratspannung angelegt wird, die während der Beschichtung verändert wird, wobei es sich bei der Substratspannung um eine bipolar gepulste Gleichspannung mit einer Frequenz von 0,1 kHz bis 10MHz handelt.

Die DE 198 26 259 A1 stellt sich die Aufgabe, ein für industrielle Chargengrößen einsetzbares, hoch skalierbares Verfahren sowie eine Einreichung zu seiner Durchführung anzugeben, welches es gestattet, Substrate gleichmäßig und mit hohen Raten zu beschichten und eine verschleißfeste und reibmindernde Multilagenstruktur anzugeben.

Gemäß DE 198 26 259 A1 wird diese Aufgabe beim Plasma-CVD-Beschichtungsverfahren durch eine Trennung der Substratspannungserzeugung von der zur Plasmaerzeugung erforderlichen Spannung gelöst, was nach der Lehre der DE 198 26 259 A1 eine gezielte Einflussnahme auf die physikalischen Eigenschaften der erzeugten Schichten erlaubt. Insbesondere wird in der DE 198 26 259 A1 beschrieben, dass die Trennung von Plasmaerzeugung und Substratspannungserzeugung auch eine Regelung der Substrattemperatur erlaubt. Beschichtungen können gemäß DE 198 26 259 A1 vielfach bei Temperaturen von 200°C und darunter erfolgen.

Als Substratspannung wird gemäß DE 198 26 259 A1 eine gepulste bipolare Gleichspannung eingesetzt, die hinsichtlich Größe und Dauer des Negativimpulses, Größe und Dauer des Positivimpulses sowie der spannungsfreien Zwischenintervalle bzw. Pausenzeiten änderbar ist. Nachteilig an dem Verfahren der DE 198 26 259 A1 ist jedoch der große technische Aufwand, mit welchem die Substrattemperatur durch die Trennung von Plasmaerzeugung und Substratspannungserzeugung geregelt werden kann und welche beim Heißdraht-CVD-Diamantbeschichtungsverfahren nicht eingesetzt werden kann, da die technische Funktionsweise eine völlig andere ist.

Darüber hinaus beschreibt die CA 2 512 731 C ein Erwärmen der Wände einer Plasma-CVD-Beschichtungskammer, bei welcher Wasserstoffatome aus dem Plasma rekombinieren und somit nicht mehr an der Reaktion teilnehmen können. Um dieses Problem zu lösen, wird ein Verfahren zur Erzeugung eines Plasmas in der Nähe eines zu beschichtenden Substrates vorgeschlagen, wobei das Substrat einem Gas ausgesetzt wird, welches wenigstens Wasserstoff und Kohlenstoff enthält, wobei ein gepulstes Mikrowellenplasma mit einer Spitzenleistungsdichte von wenigstens 1OOW/cm³ zum Einsatz kommt, wobei die zwischen 700°C und 1000°C und der Druck zwischen 1OO mbar und 350 mbar gehalten wird. Mit einem derartigen Verfahren werden hohe Diamantabscheideraten und hohe Qualitäten der Diamantfilme erzielt.

Darüber hinaus sind noch Laser-CVD-Beschichtungsverfahren im Stand der Technik beschrieben. Beispielsweise offenbart die WO 9426425 A1 ein gepulstes Laserverfahren zum Beschichten eines Substrates aus einem Gasgemisch aus Wasserstoff und einem Kohlenwasserstoff.

Darüber hinaus beschreibt die US 2006 / 0 219 158 A1 ein Verfahren zur CVD-Beschichtung mittels Heißdraht, wobei zwischen zwei Operationsmodi 1 und 2 gearbeitet wird. Operationsmodus 1 weist eine Prozesstemperatur von 700 °C für 20 s auf, während Operationsmodus 2 eine Prozesstemperatur von 900 °C für 20 s aufweist.

Somit ist es die technische Aufgabe der vorliegenden Erfindung, ein Heißdraht-CVD-Diamantbeschichtungsverfahren zur Verfügung zu stellen, bei welchem die Substrattemperatur soweit abgesenkt wird, dass einerseits noch eine ausreichende Kristallisation von CVD-Diamant auftritt und andererseits die gewünschten Anwendungseigenschaften des Substrates nicht relevant beeinflusst oder gar zerstört werden. Zum Dritten muß die Temperatur des Heißdrahtes so hoch liegen, daß ausreichend Radikale zur Schichtsynthese bereitstehen.

Die Lösung dieser Aufgabe erfolgt durch die kennzeichnenden Merkmale des Patentanspruchs 1.

Insbesondere wird die Aufgabe dadurch gelöst, dass die Leistungseinbringung und die Heizdrähte basierend auf einer Grundlage, die für sich genommen die Beschichtungskammer zu einer Temperatur, die im unteren Bereich der für die Kristallisation und Schichtanbindung notwendigen liegt, welche "Basistemperatur" genannt wird, aufheizen würde, pulsweise nur soweit erhöht wird, dass ausreichend Radikale entstehen, um einen Beschichtungsschub zu erreichen. Dieser Leistungspuls wird maximal solange geführt, bis die für die Kristallisation und Schichtanbindung maximal zulässige Substrattemperatur erreicht wird. Auf diesen Schub folgt eine Phase, in der nur die Grundlast eingespeist wird und die Substrattemperatur wieder auf die Basistemperatur absinkt. Dann beginnt der Zyklus von neuem und endet nach der Gesamtdauer t_{Ges} des Beschichtungsverfahrens. Hierbei beträgt die Basisleistung P_{Bas} substratabhängig während der Grundlastphase ca. 50 - 75% der Leistung in der Pulsphase.

Die vorliegende Erfindung betrifft ein Verfahren zum Beschichten von Funktionsbereichen spanabhebender Werkzeuge oder Schneidsätze mit polykristallinem Diamant in einem Heißdraht-CVD-Verfahren, wobei Wasserstoff und wenigstens ein Kohlenstoffträgergas in eine Beschichtungskammer eingespeist werden, wobei sich die eingespeisten Gase an einem elektrisch beheizten Draht derart aufspalten, dass sich Kohlenstoffradikale bilden, welche sich auf dem temperaturempfindlichen Substrat in Form seiner Diamantmodifikation abscheidet, wobei das Substrat in der unter vermindertem Druck stehenden Beschichtungskammer angeordnet ist und wobei eine zur elektrischen Beheizung des Drahtes erforderliche elektrische Leistung einstellbar ist, wobei das Verfahren hinsichtlich der zur elektrischen Beheizung des Drahtes eingespeisten elektrischen Leistung zyklisch geführt wird, wobei eine Basisleistung P_{Bas} als unterer Schwellwert für eine vorbestimmte Zeit t₁ eingespeist wird (Grundlastphase), welche für eine weitere vorbestimmte Zeit t₂ eine Maximalleistung P_{Max} als oberen Schwellwert angehoben wird (Pulsphase) und dann wieder auf die Basisleistung P_{Bas} abgesenkt wird; wobei das Verfahren für eine Gesamtdauer von t_{Ges} durchgeführt wird; und wobei die Basisleistung P_{Bas} substratabhängig während der Grundlastphase ca. 50 - 75% der Leistung in der Pulsphase beträgt.

Obwohl grundsätzlich gepulste Verfahren aus den Plasma-CVD- und Laser-CVD-Diamantbeschichtungsverfahren bekannt sind, lassen sich diese Prinzipien nicht auf das Heißdraht-CVD-Diamantbeschichtungsverfahren übertragen, da hier völlig andere physikalische Umgebungsbedingungen gegeben sind. Insbesondere ist sämtlichen anderen als den Heißdraht-CVD-Diamantbeschichtungsverfahren gemeinsam, dass wenn die Ionenquelle abgeschaltet wird, man praktisch eine ON/OFF-Situation vorfindet, d. h. man hat höchstens noch "Nachfliegzeiten" der Ionen zu berücksichtigen, die bereits in Richtung Substratoberfläche beschleunigt wurden. Diese "Nachfliegzeiten" liegen im Nanosekunden- bis Mikrosekundenbereich. Im Gegensatz zur vorliegenden Erfindung beim Heißdraht-CVD-Verfahren war es überraschend, dass das Versorgen mit gepulster Heizleistung des heißen Drahtes tatsächlich zu sinnvollen Diamantabscheideraten bei gleichzeitiger Temperaturerniedrigung des Substrates führt.

Für den Fachmann war es ferner nicht vorhersehbar, dass es im Rahmen der vorliegenden Erfindung ohne Störung der Beschichtung möglich ist, durch gepulste Beheizung des heißen Filamentes eine solche Substrattemperatur herzustellen, dass dieses in seinen kristallographischen und Gefügeeigenschaften nicht verändert wird. Beispielsweise darf bei der Beschichtung von Schneideinsätzen aus polykristallinem Diamant (PKD), welcher aus nanokristallinen CVD-Diamanten mit einer Korngrößenverteilung zwischen 0,1 und 50 µm gesintert ist, die Substrattemperatur von 650°C nicht überschritten werden, da sonst eine Graphitisierung des PKD, verbunden mit einem signifikanten Festigkeitsverlust auftritt. Um diese Temperatur zu erreichen, darf die in die Heizdrahtanordnung einer kommerziellen Beschichtungsanlage eingespeiste Leistung 14 kW nicht überschreiten. Dies entspricht einer Filamenttemperatur von ca. 2000°C. Unter diesen Bedingungen ergeben sich Diamantabscheideraten von < 30 nm/h, was nicht wirtschaftliche Abscheideraten sind, da die Beschichtung zu lange dauern würde.

Die Unteransprüche stellen bevorzugte Ausführungsformen der vorliegenden Erfindung dar.

Bei der praktischen Durchführung des vorliegenden Verfahrens hat sich eine Dauer t₁ der Grundlastphase zwischen 1 µs und 120 s als vorteilhaft herausgestellt.

Die Dauer t₂ der Pulsphase liegt bevorzugt zwischen 1 µs und 60 s, was im Dauerbetrieb zu gleichmäßigen Beschichtungen bei sinnvollen Diamantabscheideraten führt.

Die Gesamtdauer t_{Ges} des Verfahrens liegt im Bereich von 5 bis 100 h insbesondere zwischen 50 und 60 h.

Während der Pulsphase kann die Temperatur des heißen Drahtes zwischen 2000°C und 3000°C liegen, wobei ein Wolframdraht typischerweise bevorzugt ist.

Eine vorteilhafte Ausführungsform der vorliegenden Erfindung liegt darin, dass die Temperatur des zu beschichtenden Substrates in Abhängigkeit von diesem in der Grundlastphase zwischen 500°C und 600°C und in der Pulsphase zwischen 600°C und 650°C liegt.

Mit dem vorliegenden Verfahren werden Diamantabscheideraten in der Pulsphase zwischen 100 nm/h und 200 nm/h, insbesondere ca. 150 nm/h erreicht.

Dies reicht aus, um wirtschaftlich Diamantfilme auf komplexen Geometrien eines spanabhebenden Werkzeuges zu erzeugen.

Weitere Vorteile und Merkmale der vorliegenden Erfindung ergeben sich anhand der Beschreibung eines Ausführungsbeispiels.

### Beispiel

Für eine beispielhafte Diamantbeschichtung mit dem Heißdraht-CVD-Verfahren wird im vorliegenden Beispiel ein PKD-Schneideinsatz in die Reaktionskammer einer handelsüblichen Beschichtungsanlage, z. B. einer CemeCon CC800/5 Dia-Anlage eingebracht. Der PKD-Schneideinsatz ist ein Sinterkörper aus Diamanten mit einer Korngrößenverteilung zwischen 0,1 und 50 µm. Ein derartiger Solid-PKD darf eine Substrattemperatur von 650°C nicht überschreiten, da sonst eine Rückumwandlung des kubisch kristallinen Diamanten in eine hexagonale Kristallstruktur des Kohlenstoffs stattfindet, was im Allgemeinen mit "Graphitisierung" bezeichnet wird. Solche Graphitisierungen des PKD's sind unweigerlich mit einem Festigkeitsverlust und auch der Zerstörung der Struktur des PKDs verbunden.

Zur Beschichtung eines solchen Solid-PKD-Schneideinsatzes darf die Heizdrahtanordnung der verwendeten HD-CVD-Beschichtungsanlage eine eingespeiste Leistung von 14 kW nicht überschreiten. Erfindungsgemäß wird die Leistungseinbringung mit einer Basisleistung von ca. 13,5 kW für einen Zeitraum zwischen 0,5 s bis 5 s auf 20 kW in einer Folge von Pulsphasen gesteigert, so dass für diesen kurzen Zeitraum die Filamenttemperatur des eingesetzten Wolframdrahtes auf 2500°C ansteigt. Im konstant leistungsgeführten Dauerbetrieb würde dies zu einer Diamantabscheiderate von ca. 300 nm/h führen, wobei aber auch die Substrattemperatur 900°C erreichen würde, was dann aber zu den oben beschriebenen Graphitisierungseffekten und Gitterumbauten führen würde.

Erfindungsgemäß wird die Einbringung der elektrischen Leistung auf das oben genannte Zeitfenster t₂ verkürzt und somit steigt die Substrattemperatur nicht über 650°C an, wobei die Abscheiderate noch ca. 150 nm/h beträgt. Mit dieser Diamantabscheiderate können Diamantfilme wirtschaftlich - im Beispielsfalle innerhalb von ca. 60 h - auf temperaturempfindlichen Substraten abgeschieden werden.

Bei der praktischen Durchführung des erfindungsgemäßen Verfahrens können Basisleistungen P_{Bas} substratabhängig während der Grundlastphase von 10 bis 15 KW auftreten und die Maximimalleistung P_{Max} kann substratabhängig während der Pulsphase 18 bis 30 KW betragen.

Funktionsbereiche von spanabhebenden Werkzeugen oder Schneideinsätze, welche mit dem erfindungsgemäßen Verfahren Diamant-beschichtet wurden, zeigen große Festigkeiten und lange Standzeiten und sind somit für die industrielle Produktion von spanabhebenden Werkzeugen mit Diamantbeschichtung bestens geeignet.

## Patentansprüche

1. Verfahren zum Beschichten von Funktionsbereichen spanabhebender Werkzeuge oder Schneidsätze mit polykristallinem Diamant in einem Heißdraht-CVD-Verfahren, wobei Wasserstoff und wenigstens ein Kohlenstoffträgergas in eine Beschichtungskammer eingespeist werden, wobei sich die eingespeisten Gase an einem elektrisch beheizten Draht derart aufspalten, dass sich Kohlenstoff bildet, welcher sich auf dem temperaturempfindlichen Substrat in Form seiner Diamantmodifikation abscheidet, wobei das Substrat in der unter vermindertem Druck stehenden Beschichtungskammer angeordnet ist; wobei
eine zur elektrischen Beheizung des Drahtes erforderliche elektrische Leistung einstellbar ist, wobei
das Verfahren hinsichtlich der zur elektrischen Beheizung des Drahtes eingespeisten elektrischen Leistung zyklisch geführt wird, wobei eine Basisleistung P_{Bas} als unterer Schwellwert für eine vorbestimmte Zeit t₁ während einer Grundlastphase eingespeist wird, welche für eine weitere vorbestimmte Zeit t₂ auf eine Maximalleistung P_{Max} während einer Pulsphase als oberen Schwellwert angehoben wird und dann wieder auf die Basisleistung P_{Bas} abgesenkt wird; und wobei
das Verfahren für eine Gesamtdauer von t_{Ges} durchgeführt wird,
**dadurch gekennzeichnet, dass**
die Basisleistung P_{Bas} substratabhängig während der Grundlastphase 50 - 75% der Leistung in der Pulsphase beträgt.

2. Verfahren nach Anspruch 1, **dadurch gekennzeichnet, dass** die Dauer t₁ einer Grundlastphase zwischen 1 µs und 120 s liegt.

3. Verfahren nach Anspruch 1 oder 2, **dadurch gekennzeichnet, dass** die Dauer t₂ einer Pulsphase zwischen 1 µs und 60 s liegt.

4. Verfahren nach einem der vorhergehenden Ansprüche, **dadurch gekennzeichnet, dass** die Gesamtdauer t_{Ges} 5 bis 100 h, insbesondere 50 bis 60 h, beträgt.

5. Verfahren nach einem der vorhergehenden Ansprüche, **dadurch gekennzeichnet, dass** die Temperatur des Drahtes in der Pulsphase zwischen 2000°C und 3000°C liegt.

6. Verfahren nach einem der vorhergehenden Ansprüche, **dadurch gekennzeichnet, dass** die Temperatur des zu beschichtenden Substrates substratabhängig in der Grundlastphase zwischen 500°C und 600°C und in der Pulsphase zwischen 600°C und 650°C liegt.

7. Verfahren nach einem der vorhergehenden Ansprüche, **dadurch gekennzeichnet, dass** die Diamantabscheiderate in der Pulsphase zwischen 100 nm/h und 200 nm/h, insbesondere bei ca. 150 nm/h, liegt.

8. Verfahren nach einem der vorhergehenden Ansprüche, **dadurch gekennzeichnet, dass** die Basisleistung P_{Bas} substratabhängig während der Grundlastphase 10 - 15 KW beträgt und die Maximimalleistung P_{Max} substratabhängig während der Pulsphase 18 bis 30 KW beträgt.

## Claims

1. A method for coating functional areas of metal-cutting tools or cutting sets with polycrystalline diamond in a hot-wire CVD process, wherein hydrogen and at least one carbon carrier gas are fed in a coating chamber, the fed gases being split on an electrically heated wire such that carbon is formed, which is deposited on a temperature-sensitive substrate in form of its diamond modification, the substrate being arranged in the coating chamber being under reduced pressure; wherein
an electrical power required to electrically heat the wire is adjustable, wherein
the method is implemented cyclically with respect to the electrical power supplied for heating the wire electrically, wherein a base power P_{Bas} is fed in as a lower threshold value during a base load phase for a predetermined time t1, which is raised for a further predetermined time t2 to a maximum power P_{Max} as upper threshold value during a pulse phase and then is lowered again to the base power P_{Bas}; and wherein
the method is carried out for a total duration of t_{Ges},
**characterized in that**
the base power P_{Bas} during the base load phase is 50 - 75% of the power in the pulse phase, depending on the substrate.

2. The method according to claim 1, **characterized in that** the duration t₁ of a base load phase is between 1 µs and 120 s.

3. The method according to claim 1 or 2, **characterized in that** the duration t₂ of a pulse phase is between 1 µs and 60 s.

4. The method according to any of the preceding claims, **characterized in that** the total duration t_{Ges} amounts to 5 to 100 h, in particular 50 to 60 h.

5. The method according to any of the preceding claims, **characterized in that** the temperature of the wire in the pulse phase is between 2000°C and 3000°C.

6. The method according to any of the preceding claims, **characterized in that** the temperature of the substrate to be coated is between 500°C and 600°C in the base load phase and between 600°C and 650°C in the pulse phase, depending on the substrate.

7. The method according to any of the preceding claims, **characterized in that** the diamond deposition rate in the pulse phase is between 100 nm/h and 200 nm/h, in particular approx. 150 nm/h.

8. The method according to any of the preceding claims, **characterized in that** the base power P_{Bas} is 10 - 15 KW during the base load phase, depending on the substrate, and the maximum power P_{Max} is 18 to 30 KW during the pulse phase, depending on the substrate.

## Revendications

1. Procédé de revêtement de zones fonctionnelles d'outils d'enlèvement de copeaux ou d'ensembles de coupe avec un diamant polycristallin dans un procédé CVD à fil chaud, dans lequel de l'hydrogène et au moins un gaz porteur carboné sont injectés dans une chambre de revêtement, dans lequel les gaz injectés se décomposent au niveau d'un fil chauffé électriquement de telle manière que se forme du carbone qui se précipite sur le substrat thermosensible sous la forme de sa modification en diamant, dans lequel le substrat est agencé dans la chambre de revêtement se trouvant sous pression réduite ; dans lequel
une puissance électrique nécessaire au chauffage électrique du fil est réglable, dans lequel
le procédé est réalisé de manière cyclique en ce qui concerne la puissance électrique injectée pour le chauffage électrique du fil, dans lequel une puissance de base P_{Bas} est injectée comme valeur seuil inférieure pendant un temps prédéterminé t₁ pendant une phase de charge de base qui est augmentée pendant un autre temps prédéterminé t₂ à une puissance maximale P_{Max} pendant une phase de pulsation comme valeur seuil supérieure et ensuite est de nouveau abaissée à la puissance de base P_{Bas} ; et dans lequel
le procédé est réalisé pendant une durée totale de t_{Tot},
**caractérisé en ce que**
la puissance de base P_{Bas} est comprise entre 50 et 75 % de la puissance dans la phase de pulsation en fonction du substrat pendant la phase de charge de base.

2. Procédé selon la revendication 1, **caractérisé en ce que** la durée t₁ d'une phase de charge de base est comprise entre 1 µs et 120 s.

3. Procédé selon la revendication 1 ou 2, **caractérisé en ce que** la durée t₂ d'une phase de pulsation est comprise entre 1 µs et 60 s.

4. Procédé selon l'une quelconque des revendications précédentes, **caractérisé en ce que** la durée totale t_{Tot} est comprise entre 5 et 100 h, en particulier 50 et 60 h.

5. Procédé selon l'une quelconque des revendications précédentes, **caractérisé en ce que** la température du fil dans la phase de pulsation se situe entre 2000 °C et 3000 °C.

6. Procédé selon l'une quelconque des revendications précédentes, **caractérisé en ce que** la température du substrat à revêtir se situe selon le substrat entre 500 °C et 600 °C dans la phase de charge de base et entre 600 °C et 650 °C dans la phase de pulsation.

7. Procédé selon l'une quelconque des revendications précédentes, **caractérisé en ce que** la vitesse de précipitation en diamant dans la phase de pulsation se situe entre 100 nm/h et 200 nm/h, en particulier à environ 150 nm/h.

8. Procédé selon l'une quelconque des revendications précédentes, **caractérisé en ce que** la puissance de base P_{Bas} est comprise selon le substrat entre 10 et 15 KW pendant la phase de charge de base et la puissance maximale P_{Max} est comprise selon le substrat entre 18 et 30 KW pendant la phase de pulsation.
